# EUROPEAN PATENT APPLICATION

(11) **EP 4 471 869 A1**
(43) Date of publication of application: **04.12.2024**
(21) Application number: 24315235.2
(22) Date of filing: 16.05.2024
(51) Int. Cl.: H01L 29/423, H01L 29/20, H01L 29/40, H01L 29/66, H01L 29/778, H01L 29/10

(54) **HEMT DEVICE HAVING AN IMPROVED CONDUCTIVITY AND MANUFACTURING PROCESS THEREOF**

(30) Priority: 31.05.2023 IT 202300011076
(71) Applicant: STMicroelectronics International N.V., 1228 Plan-les-Ouates, Geneva (CH)
(72) Inventor: Castagna, Maria Eloisa, 95123 CATANIA (IT); Giorgino, Giovanni, 95041 CALTAGIRONE (CT) (IT); Iucolano, Ferdinando, 95030 GRAVINA DI CATANIA (CT) (IT); Tringali, Cristina, 96011 AUGUSTA (SR) (IT); Constant, Aurore, 37100 TOURS (FR)
(74) Representative: Studio Torta S.p.A.

(57) **Abstract**

A HEMT device (20;200) including: a semiconductor body (22) forming a semiconductive heterostructure (24,26); a gate region (27) arranged on the semiconductor body (22) and elongated along a first axis (Y); a gate metal region (50) including a respective lower portion (50'), which is arranged on the gate region (27) and is laterally recessed with respect to the gate region (27), and a respective upper portion (50"), which is arranged on the lower portion (50') and has a width greater that the lower portion (50') along a second axis (X); a source metal region (45) extending on the semiconductor body (22) and made at least in part of aluminium; a drain metal region (46) of conductive material, extending on the semiconductor body (22), the source metal region (45) and the drain metal region (46) extending on opposite sides of the gate region (27); a first conductivity enhancement region (35) of aluminium nitride, extending on the semiconductor body (22) and laterally interposed between the source metal region (45) and the gate region (27), the first conductivity enhancement region (35) being in direct contact with the source metal region (45) and being separated from the gate region (27).

## Description

### Technical Field

The present invention relates to a High Electron Mobility Transistor (HEMT) having an improved conductivity and to the manufacturing process thereof.

### Background

As known, the HEMT devices, also known as heterostructure field effect transistors (HFET), are finding wide diffusion, thanks to the possibility of operating at high voltages, their high breakdown voltage and a high density ad mobility.

In an HEMT device, a semiconductive heterostructure (based generally on AlGaN/GaN layers) allows a so-called 2-dimensional electron gas (2DEG) to be spontaneously generated in the device, thereby forming a channel path for electrical charges. The spontaneous channel may be modulated by applying suitable voltages at a gate region, over the channel path.

AlGaN/GaN HEMTs are normally depletion-mode. However, for practical applications, enhancement mode (normally off) devices are preferred to obtain safe operation and to drive circuits simplification.

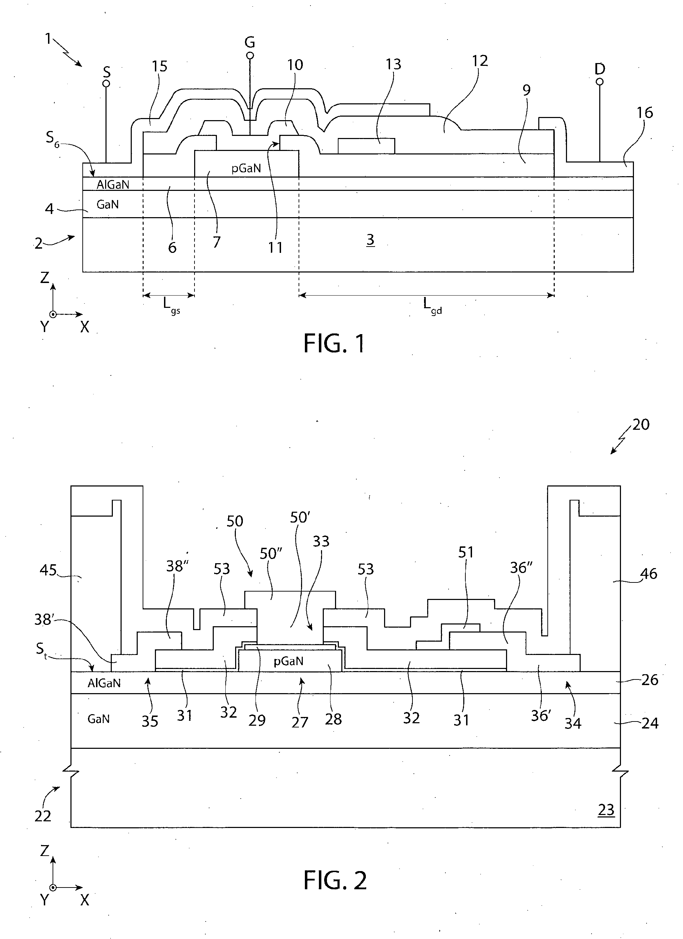

Several approaches to achieve normally-off HEMTs based on AlGaN/GaN layers have been proposed, including forming the gate region of p-GaN, as shown as an example in Figure 1, which shows an orthogonal reference system XYZ. In particular, Figure 1 shows an HEMT device 1, which includes a semiconductor body 2 comprising a substrate layer 3, a first layer 4 and a second layer 6 (hereinafter also referred to as channel layer 4 and barrier layer 6).

The substrate layer 3 may comprise a silicon substrate and a gallium nitride (GaN) buffer layer, not shown separately in Figure 1.

The channel layer 4 is of a first semiconductor material, such as for example a first semiconductive alloy of elements of the groups III and V of the periodic table; for example, the channel layer 4 may be of gallium nitride (GaN).

The barrier layer 6 overlies, and is in direct contact with, the channel layer 4, and is of a second semiconductor material, such as, for example, a second semiconductive alloy, different from the first semiconductive alloy, of elements of the groups III-V of the periodic table. For example, the barrier layer 6 may be of aluminium gallium nitride (AlGaN). The channel layer 4 and the barrier layer 6 are for example of N-type.

In greater detail, the barrier layer 6 is delimited ad top by a front surface S₆, which is parallel to the plane XY. The channel layer 4 and the barrier layer 6 extend parallel to the plane XY.

A gate region 7 of conductive material extends on the barrier layer 6. The gate region 7, also known as channel modulating region, is formed, for example, by a third semiconductor material, such as for example a third semiconductive alloy of elements of the groups III and V of the periodic table; in particular, the gate region 7 is formed here by gallium nitride of P conductivity type (pGaN).

A first insulating region 9, for example of silicon oxide, extends on the barrier layer 6, on the lateral surfaces and on an upper surface of the gate region 7.

An opening 11 extends through the first insulating region 9, on top of the gate region 7, and a gate metal region 10, for example of TiN/AlCu/TiN, extends in the opening 11, in direct electrical contact with the gate region 7, and partially on the first insulating region 9.

A second insulating region 12, for example of silicon oxide, extends on the first insulating region 9 and on the gate metal region 10.

A field plate 13, of conductive material, may extend on the first insulating region 9, laterally to the gate metal region 10, and below the second insulating region 12.

A source metal region 15, for example of Ti/AlCu/TiN, extends on, and laterally to, the second insulating region 12 and is in direct electrical contact with the barrier layer 6. In particular, a portion of the source metal region 15 contacts the barrier layer 6; such a portion of the source metal region 15 is laterally (i.e., along the X axis) staggered with respect to the gate region 7. Furthermore, in the HEMT device 1, the source metal region 15 has a portion extending over the gate metal region 10 and over the field plate 13 and has a shielding function.

A drain metal region 16, for example of Ti/AlCu/TiN, extends on, and laterally to, the second insulating region 12. In particular, the drain metal region 16 is laterally staggered with respect to the gate region 7, so as to extend on an opposite side of the gate region 7 with respect to the source metal region 15. Furthermore, a portion of the drain metal region 16 extends on the barrier layer 6, in direct contact.

In Figure 1, the lateral distance between the portion of the source metal region 15 that contacts the barrier layer 6 and the gate region 7 is designated by L_{gs} (so-called gate-source distance), whereas the lateral distance between the portion of the drain metal region 16 that contacts the barrier layer 6 and the gate region 7 is designated by L_{gd} (so-called gate-drain distance).

In addition, the HEMT device 1 is a so-called not self-aligned device, because, in that concerns the gate metal region 10, its manufacturing process provides for: initially, forming the gate region 7; then, forming the first insulating region 9; then, forming the opening 11; and then forming the gate metal region 10. Therefore, the gate metal region 10 is formed after the formation of the gate region 7 (i.e., after the corresponding etching), as opposed to forming the gate region 7 and the gate metal region 10 through the same etching. In this way, the gate metal region 10 is mushroom shaped; furthermore, this kind of manufacturing process improves the reliability of the HEMT device 1 at high gate bias, because it provides for a greater control of the dimensions of the gate metal contact.

Furthermore, variant are known, which include an additional insulating region (not shown in Figure 1) of silicon nitride (Si₃N₄), arranged at least in part on the first insulating region 9, so that the field plate includes a first and a second portion, laterally staggered and extending respectively on the first insulating region 9 and on the additional insulating region, at different heights, thereby reducing the capacity of the HEMT device 1 and raising the breakdown voltage.

This having been said, the gate-drain distance L_{gs} is designed so that the HEMT device 1 is able to withstand high gate-drain voltage V_{gd}; therefore, the gate-drain distance L_{gd} generally cannot be reduced under a certain threshold. On the contrary, ideally, by reducing the gate-source distance L_{gs}, it is possible to reduce the so-called resistance R_{ON}, as well as to raise the saturation current and to reduce the voltage drop on the gate-source voltage V_{gs}. However, in order to form the abovementioned mushroom shape of the gate metal region 10, it is not possible to excessively reduce the gate-source distance L_{gs}. Furthermore, the gate-source distance L_{gs} has to be great enough to allow separate etching processes for the definition of the gate metal region 10 and the source metal region 15.

Thus, an aim of the invention is to overcome at least in part the drawbacks and limitations of the prior art.

### Summary

According to the present invention, there are provided an HEMT device and the manufacturing process thereof, as defined in the appended claims.

### Brief Description of the Drawings

For the understanding of the present invention, embodiments thereof are now described, purely as a non-limitative examples, with reference to the enclosed drawings, wherein:
- Figure 1 schematically shows a cross-section of a known HEMT device;
- Figure 2 schematically shows a cross-section of a HEMT device according to an embodiment;
- Figures 3-16 schematically show cross-sections of a semiconductor wafer in subsequent manufacturing steps of the HEMT device of Figure 2;
- Figure 17 schematically shows a cross-section of a HEMT device according to another embodiment; and
- Figures 18-21 schematically show cross-sections of a semiconductor wafer in subsequent manufacturing steps of the HEMT device of Figure 17.

### Description of Embodiments

Figure 2 shows an orthogonal reference system XYZ and a HEMT device 20, which comprises a semiconductor body 22, here formed by a substrate 23, a channel layer 24 and a barrier layer 26.

The substrate 23 may comprise a silicon substrate and a gallium nitride (GaN) buffer layer, not shown separately in Figure 2.

The channel layer 24 is of a first semiconductor material, such as a first semiconductive alloy of elements of the groups III and V of the periodic table; for example, the channel layer 24 may be of gallium nitride (GaN).

The barrier layer 26 overlies the channel layer 24, in direct contact, and is of a second semiconductor material, such as a second semiconductive alloy, different from the first semiconductive alloy, of elements of the groups III-V of the periodic table. For example, the barrier layer 26 may be of aluminium gallium nitride (AlGaN).

The channel layer 24 and the barrier layer 26 are for example of N-type.

In greater detail, the barrier layer 26 is delimited ad top by a front surface Sₜ, which is parallel to the plane XY. The channel layer 24 and the barrier layer 26 extend parallel to the plane XY.

A gate region 27, of conductive material, extends on the barrier layer 56, in direct contact, above the front surface Sₜ. In a manner not shown, the gate region 27 is strip-shaped and extends parallel to the Y axis; in other words, the gate region 27 is elongated along the Y axis.

In the example of Figure 2, the gate region 27 comprises a channel modulating region 28 of pGaN (gallium nitride of P conductivity type). As known to the person skilled in the art, the channel modulating region 28 operates to modulate the thickness of the conductive channel (i.e, the 2-dimensional electron gas-2DEG) formed at the interface between the channel layer 24 and the barrier layer 26, based on the voltage applied thereto.

According the embodiment shown in Figure 2, the gate region 27 further comprises an interlayer region 29 (optional), which extends on the channel modulating region 28, in direct contact.

The interlayer region 29 may be of a material such as TiN. Furthermore, in the embodiment of Figure 2, the interlayer region 29 has a smaller width (parallel to the X axis) than the channel modulating region 28.

The HEMT device 20 further comprises a sealing region 31, which is made of a non-conductive material (e.g., an oxide such as Al₂O₃) and covers the lateral sides and part the upper side of the channel modulating region 28; in particular, the sealing region 31 covers, in direct contact, a portion of the channel modulating region 28 left exposed by the interlayer region 29. Furthermore, the sealing region 31 covers, in direct contact, the lateral sides and part of the upper side of the interlayer region 29, so as to laterally delimit a lower portion of a gate opening 33, which extends through the sealing region 31 and is delimited, at bottom, by a portion of the interlayer region 29.

In addition, the sealing region 31 extends, in direct contact, on portions of the barrier layer 26 that are laterally staggered with respect to the overlying channel modulating region 28.

The HEMT device 20 further comprises a first and a second dielectric regions 32, 34, a transformed region 35, a source metal region 45, a drain metal region 46 and a gate metal region 50.

In detail, the first dielectric region 32 is made of silicon oxide (e.g., a TEOS oxide) and extends on the sealing region 31, in direct contact. An inner portion of the first dielectric region' 32 is traversed by the gate opening 33.

The second dielectric region 34 is made, as an example, of silicon nitride (Si₃N₄) and includes a first and a second portion 36', 36", which form a single monolithic region. The first portion 36' is laterally staggered with respect to the sealing region 31 and the first dielectric region 32, so as to extend on a corresponding portion of the barrier layer 26, in direct contact. The first portion 36' laterally contacts the sealing region 31 and the first dielectric region 32. The second portion 36" extends on a first peripheral portion of the first dielectric region 32, so that the first and the second portions 36', 36" define a step profile.

The transformed region 35 is made of aluminium nitride (AlN) and includes a respective first portion 38' and a respective second portion 38".

The first portion 38' is laterally staggered with respect to the sealing region 31 and the first dielectric region 32, so as to extend on a corresponding portion of the barrier layer 26, in direct contact. In particular, the first portion 38' of the transformed region 35 and the first portion 36' of the second dielectric region 34 are arranged, at a distance, on opposite sides of the channel modulating region 28. Furthermore, the first portion 38' of the transformed region 35 laterally contacts the sealing region 31 and the first dielectric region 32.

The second portion 38" of the transformed region 35 extends on a second peripheral portion of the first dielectric region 32, so that the first and the second portions 38', 38" define a step profile. In particular, the abovementioned first peripheral portion of the first dielectric region 32 and the second peripheral portion of the first dielectric region 32 are arranged, at a distance, on opposite sides of gate region 27.

The source metal region 45 is formed by aluminium or an aluminium-alloy (e.g., AlCu) and extends, in direct contact, on a corresponding portion of the barrier layer 26, which is left exposed by the first portion 38' of the transformed region 35. In particular, a lower portion of the source metal region 45 contacts said corresponding portion of the barrier layer 26 and laterally contacts' the first portion 38' of the transformed region 35.

The drain metal region 46 is formed by aluminium or an aluminium-alloy (e.g., AlCu) and extends, in direct contact, on a corresponding portion of the barrier layer 26, which is left exposed by the first portion 36' of the second dielectric region 34. In particular, a lower portion of the drain metal region 46 contacts said corresponding portion of the barrier layer 26 and laterally contacts the first portion 36' of the second dielectric layer 34.

The gate metal region 50 is formed, as an example, by a multilayer of TiN/AlCu/TiN and extends in the gate opening 33, in direct contact with the underlying interlayer region 29, so that the interlayer region 29 improves the Schottky contact between the gate metal region 50 and the channel modulating region 28.

In practice, the source metal region 45 and the drain metal region 46 extend on different sides of gate region 27.

The HEMT device 20 further comprises a field plate 51 and a third dielectric region 53, which acts as a passivation region.

The field plate 51 is made of a conductive material and includes an upper portion, which extends, in direct contact, on the second portion 36" of the second dielectric region 34, and a lower portion, which extends, in direct contact, on a corresponding portion of the first dielectric region 32, so that the field plate 51 defines a step profile. Furthermore, the field plate 51 is arranged between the gate metal region 50 and the drain metal region 46; furthermore, the field plate 51 may be formed by the same materials as the gate metal region 50 and may be electrically connected to source metal region 45.

The third dielectric region 53 is made of silicon oxide (e.g., a TEOS oxide) and extends, in direct contact, on the field plate 51, on the parts of the second dielectric region 34 left exposed by the field plate 51, on the transformed region 35 and on the parts of the first dielectric region 32 left exposed by the transformed region 35, the field plate 51 and the second dielectric region 34. Furthermore, the third dielectric region 53 laterally coats the source metal region 45 and the drain metal region 46. In addition, as shown in Figure 2, the third dielectric region 53 may extend also on top of the source metal region 45 and the drain metal region 46; however, though not shown in Figure 2, openings are present in the third dielectric region 53, which allow to expose corresponding top portions of the source metal region 45 and the drain metal region 46, to allow the formation of corresponding electric contacts.

Furthermore, the gate opening 33, besides extending through the first dielectric region 32 and the sealing region 31, also extends through the third dielectric region 53. Therefore, the gate metal region 50 extends through the third dielectric region 53; in addition, part of the gate metal region 50 extends on the third dielectric region 53, in direct contact.

In greater detail, the gate metal region 50 includes a respective lower portion 50', which extends in the gate opening 33 and has a width (parallel to the X axis) lower than the widths of the channel modulating region 28 and the interlayer region 29; furthermore, the lower portion 50' is laterally recessed with respect to the underlying gate region 27 (i.e., along the X axis, the channel modulating region 28 and the interlayer region 29 protrude on both sides with respect to the lower portion 50'). Furthermore, the gate metal region 50 includes a respective upper portion 50", which extends on the lower portion 50', as well as on top of the third dielectric region 53; the upper portion 50" has a width greater than the width of the lower portion 50'.

In practice, the gate metal region 50 has a mushroom shape, which confers, along with the fact that the lower portion 50' is laterally recessed with respect to the underlying gate region 27, electrical reliability to the HEMT device 20. Furthermore, the Applicant has noticed that the presence of the transformed region 35 causes an increase of the conductivity of the portion of the conductive channel that is arranged under the transformed region 35, thereby improving the performances of the HEMT device 20. In practice, the transformed region 35 acts as a conductivity enhancement region.

Furthermore, the field plate 51 allows to modulate the electric field between the drain metal region 46 and the gate metal region 50, so as to reduce the peaks of the electric field close to the channel modulating region 28 and in the portions of the second dielectric region 34 adjacent to the drain metal region 46. In addition, owing to the presence of two different dielectric materials that form, respectively, the first and the second dielectric regions 32, 34, the field plate 51 can be formed by patterning the second dielectric region 34 through a selective etching, as opposed to a time etching, thereby achieving a precise control of the shape of the field plate 51, as explained in greater detail in the following.

The HEMT device 20 may be manufactured as shown in the following Figures, which show a wafer 100 before dicing, the wafer 100 including the semiconductor body 22, namely including the substrate 23, the channel layer 24 and the barrier layer 26.

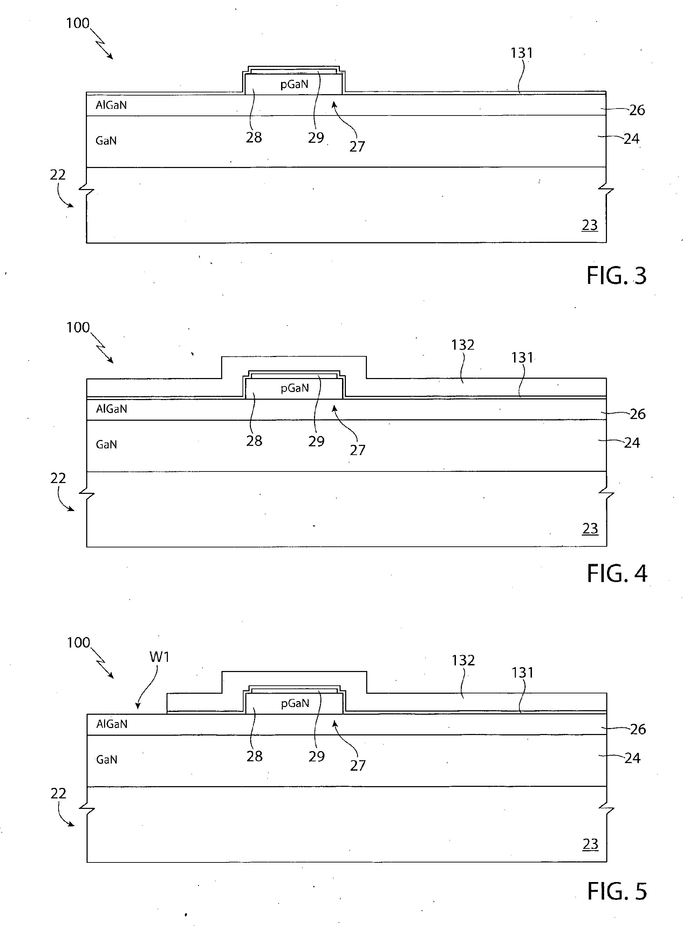

As shown in Figure 3, initially the wafer 100 is worked in a per se known manner, so as to form the channel modulating region 28 and the interlayer region 29. As an example, though not shown in detail, the channel modulating region 28 and interlayer region 29 may be formed by sputtering a TiN layer on a pGaN layer (not shown, grown epitaxially on barrier layer 26) and by lithographically defining the TiN layer and the pGaN layer using a single mask (also not shown) with a lateral etch to obtain the smaller width of interlayer region 29; however any other manufacturing steps are possible, for example by using two different masks. Furthermore, a sealing layer 131 is formed on the gate region 27 and on the barrier layer 26, where exposed; as an example, the sealing layer 131 is thermally or plasma deposited with an ALD (Atomic Layer Deposition) technique in a H₂O or O₃ based environment at 300°C for a thickness in the range [2nm-10nm] (e.g., 2, 5nm) .

Subsequently, as shown in Figure 4, a first dielectric layer 132 is formed on the sealing layer 131; as an example, the first dielectric layer 132 is formed by depositing silicon oxide through PECVD (Plasma Enhanced Chemical Vapour Deposition) in a SiH₄-based environment. The first dielectric layer 132 may have a thickness comprised, as an example, in the range [20nm-300nm] (e.g., 200nm).

Then, as shown in Figure 5, portions of the sealing layer 131 and the first dielectric layer 132 are removed by means of an etching process, so as to define a first window W1, which faces a corresponding exposed portion of the barrier layer 26, which is intended to contact the source metal region 45 and the first portion 38' of the transformed region 35.

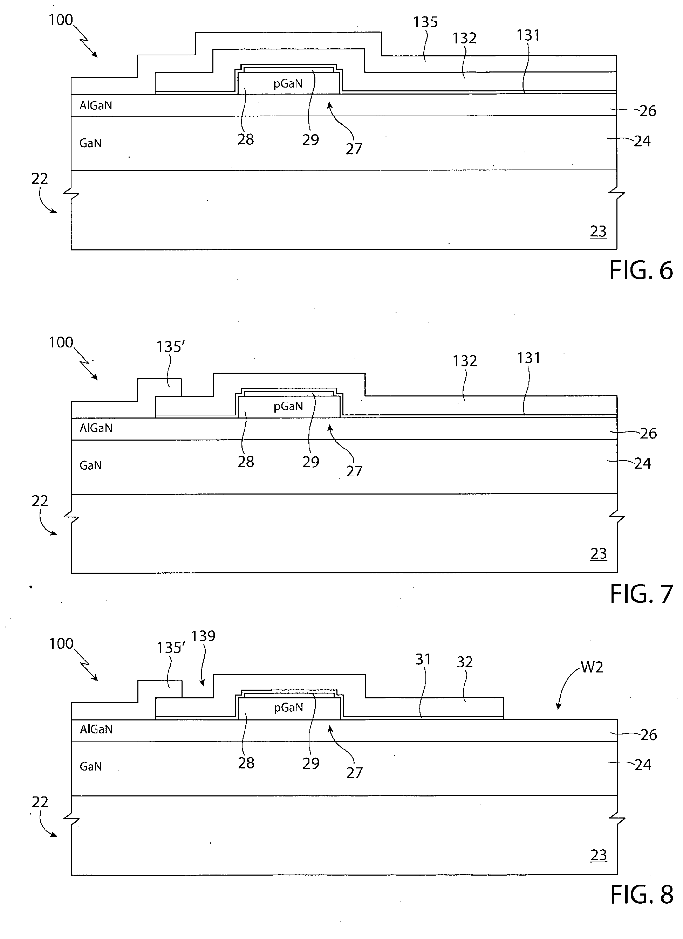

Then, as shown in Figure 6, a second dielectric layer 135 of silicon nitride is formed on the first dielectric layer 132 and on the exposed portion of the barrier layer 26, i.e. inside the first window W1. An example, the second dielectric layer 135 is formed by depositing silicon nitride through PECVD. The second dielectric layer 135 may have a thickness comprised, as an example, in the range [50nm-300nm] (e.g., 100nm). In the following reference is made to the silicon nitride of the first type to refer to the silicon nitride forming the second dielectric layer 135.

In greater detail, the silicon nitride of the first type is a silicon-rich silicon nitride, which has a percentage of silicon such that its refractive index is greater or equal to 1,95; as an example, the refractive index of the silicon nitride of the first type is greater or equal to 2.

Subsequently, as shown in Figure 7, the portions of the second dielectric layer 135 are selectively removed, so as to expose a portion of the first dielectric layer 132, which overlies the gate region 27. The remaining portion of the second dielectric layer 135 forms a residual dielectric region 135', which is made of the abovementioned silicon nitride of the first type. As explained in the following, the residual dielectric region 135' acts as a preliminary region.

Then, as shown in Figure 8, portions of the sealing layer 131 and the first dielectric layer 132 are removed by means of an etching process, so as to define a second window W2, which faces a corresponding exposed portion of the barrier layer 26, which is intended to contact the drain metal region 46 and the first portion 36' of the second dielectric region 34. The remaining portions of the sealing layer 131 and the first dielectric layer 132 respectively form the sealing region 31 and the first dielectric region 32.

The residual dielectric region 135' laterally delimits a recess 139, which is also laterally delimited by a corresponding portion of the first dielectric region 32 that extends on the gate region 27. The recess 139 is delimited at bottom by a portion of the first dielectric region 32 that is laterally staggered with respect to the gate region 27.

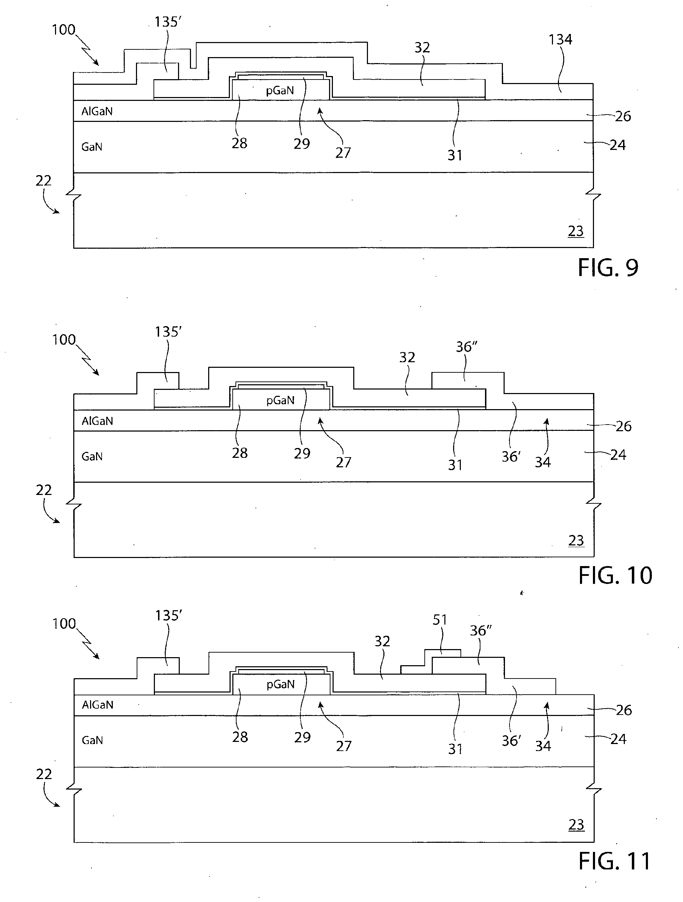

Then, as shown in Figure 9, a third dielectric layer 134 of silicon nitride is formed on the residual dielectric region 135', on the first dielectric region 32 and on the exposed portion of the barrier layer 26, i.e. inside the second window W2, as well as inside the recess 139. As an example, the third dielectric layer 134 is formed by depositing silicon nitride through PECVD. The third dielectric layer 134 may have a thickness comprised, as an example,in the range [50nm-300nm] (e.g., 80nm). In the following reference is made to the silicon nitride of the second type to refer to the silicon nitride forming the third dielectric layer 134.

The silicon nitride of the second type is a nitrogen-rich silicon nitride, which has a percentage of silicon such that its refractive index is lower than 1,95; as an example, the refractive index of the silicon nitride of the second type is lower than 1,9.

Then, as shown in Figure 10, a portion of the third dielectric layer 134 is selectively removed by means of an etching process. Such an etching process has an end point that is represented by the silicon oxide of the first dielectric region 32.

The remaining portions of the third dielectric layer 134 form the first and the second portions 36', 36" of the second dielectric region 34. In this way, the residual dielectric region 135' and a part of the first dielectric region 32 become exposed; in addition, the first portion 36' of the second dielectric region 34 temporarily covers also the portion of the barrier layer 26 that will contact, at the end of the manufacturing process, the drain metal region 46. Furthermore, though not shown, during this etching process, a negligible over-etch of the residual dielectric region 135' may occur.

Then, as shown in Figure 11, the field plate 51 is formed, as an example by means of a sputtering process and a subsequent selective removal process.

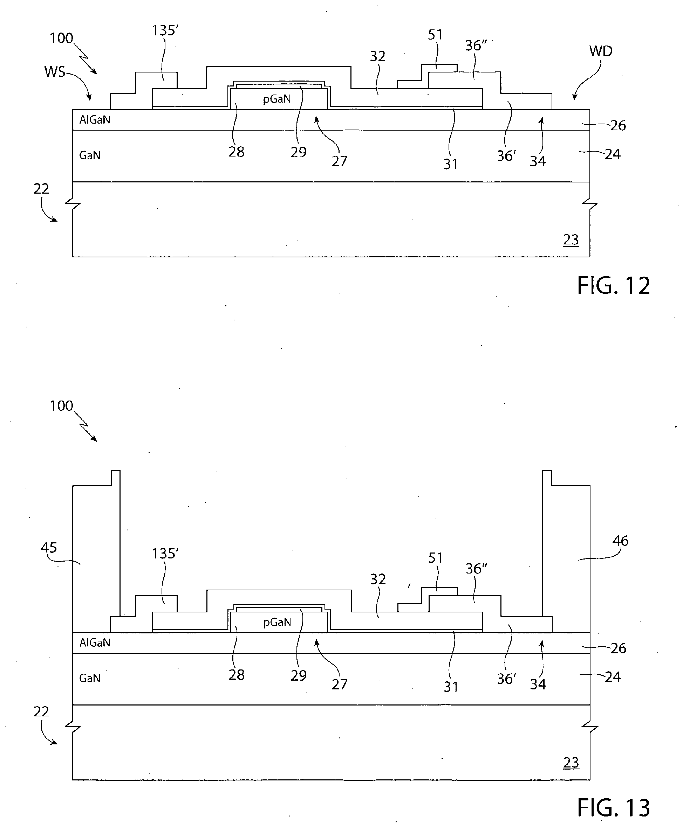

Then, as shown in Figure 12, a drain opening WD and a source opening WS are formed, respectively through the first portion 36' of the second dielectric region 34 and the residual dielectric region- 135'. In practice, the drain opening WD is formed by selectively removing a part of the first portion 36' of the second dielectric region 34, so as to expose a corresponding portion of the barrier layer 26; the source opening WS is formed by selectively removing a part of the residual dielectric region 135', so as to expose a corresponding portion of the barrier layer 26. Since both the residual dielectric region 135' and the second dielectric region 34 are of silicon nitride (albeit of different type), a single etching process is carried out to form the drain opening WD and the source opening WS.

Then, as shown in Figure 13, the source metal region 45 and the drain metal region 46 are formed, so as to extend respectively through the source opening WS and the drain opening WD. As an example, the source metal region 45 and the drain metal region 46 may be formed by sputtering an aluminium layer and by carrying out a subsequent lift-off process.

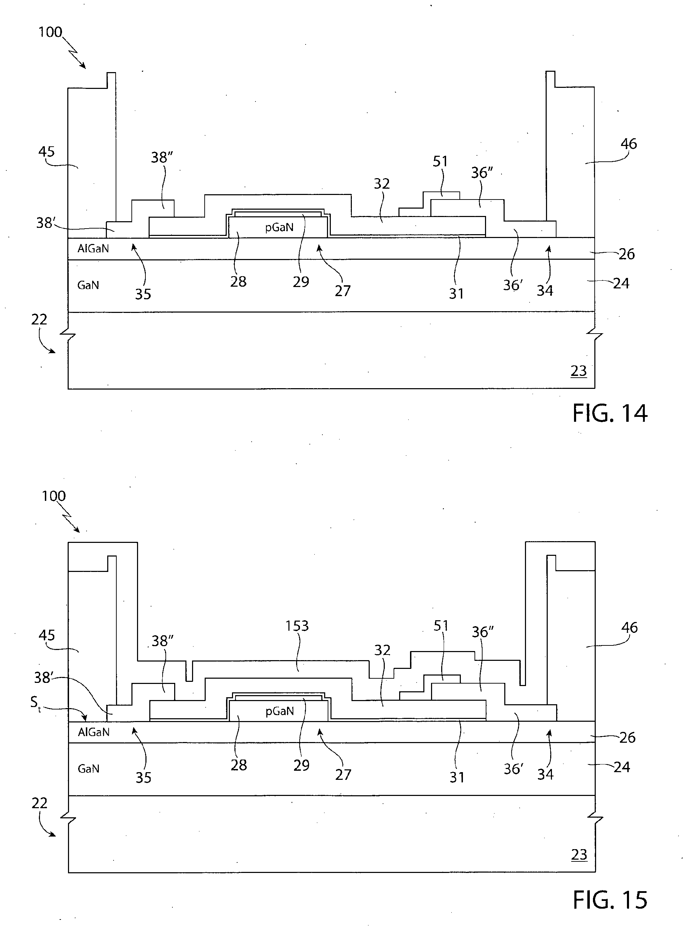

Then, as shown in Figure 14, a thermal treatment is carried out, so as to transform the remaining part of the residual dielectric region 135' into the transformed region 35.

In particular, the thermal treatment occurs, as an example, at a temperature in the range [500-600]°C (as an example, 560°C) and with a duration in the range [2-5] minutes, so as to transform the silicon nitride of the first type of the residual dielectric region 135' into aluminium nitride (AlN). To this regard, the Applicant has noticed that, during the abovementioned thermal treatment, the silicon nitride of the second type, which forms the second dielectric region 34, does not transform into aluminium nitride, as opposed to the silicon nitride of the first type.

In greater detail, the transformation of the silicon nitride of the first type of the residual dielectric region 135' into aluminium nitride (AlN) occurs owing to the presence of aluminium atoms in the source metal region 45. In particular, such a transformation proceeds, over time, starting from the portion of the residual dielectric region 135' that contacts the source metal region 45, which is transformed into the first portion 38' of the transformed region 35, towards a portion of the residual dielectric region 135' that is set apart from the source metal region 45, which is transformed into the second portion 38" of the transformed region 35.

Then, as shown in Figure 15, a fourth dielectric layer 153 is formed on the exposed portions of the transformed region 35, the field plate 51 and the first and the second dielectric regions 32, 34, as well as on the source metal region 45 and the drain metal region 46. As an example, the fourth dielectric layer 153 is formed by depositing silicon oxide through PECVD. Though not shown, openings in the fourth dielectric region 153 to expose corresponding top portions of the source metal region 45 and the drain metal region 46 are then formed in a per se known manner.

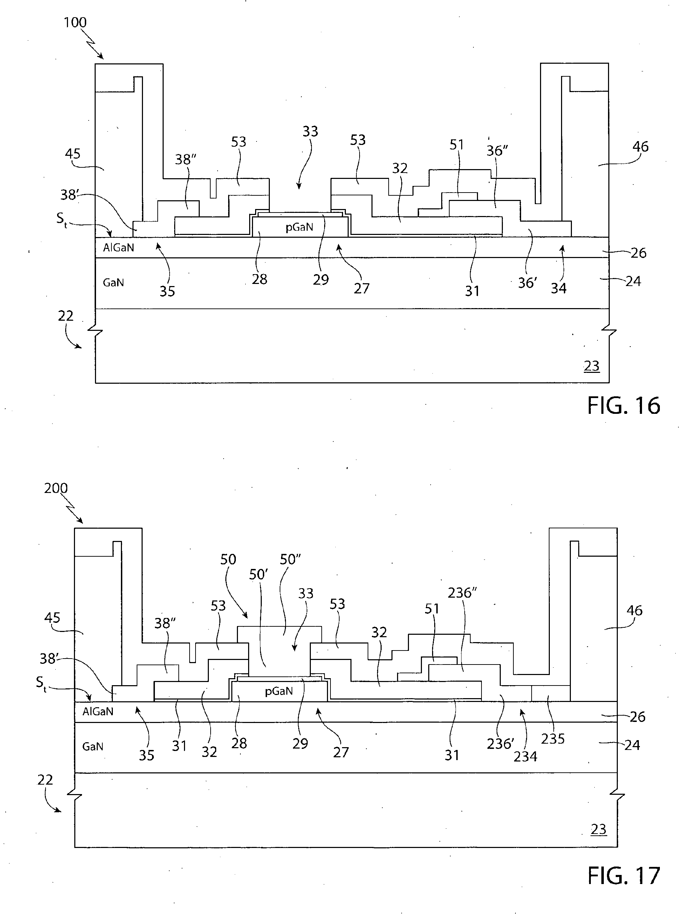

Then, as shown in Figure 16, the gate opening 33 is formed, by selectively removing a portion of the fourth dielectric layer 153 and an underlying portion of the sealing region 31; the remaining portion of the fourth dielectric layer 153 forms the third dielectric region 53. Then, though not shown, the gate metal region 50 is formed, in a per se known manner.

Then, final manufacturing steps follow, which include dicing the wafer 100, thereby obtaining the HEMT device 20 of Figure 2.

Figure 17 shows a further embodiment, which is described here below with reference to the differences with respect the embodiment of Figure 2; elements already present in the embodiment of Figure 2 are indicated in the same way, unless otherwise specified.

The HEMT device (here designated by 200) includes an additional transformed region 235 of aluminium nitride (AlN). Furthermore, the second dielectric region (here designated by 234, the corresponding first and second portions being designated by 236' and 236") is made of silicon nitride of the first type.

The additional transformed region 235 is laterally staggered with respect to the first portion 236' of the second dielectric region 234 and extends on a corresponding portion of the barrier layer 26, in direct contact; furthermore, the additional transformed region 235 laterally contacts the first portion 236' of the second dielectric region 234.

The drain metal region 46 laterally contacts the additional transformed region 235, therefore the drain metal region 46 is separated from the second dielectric region 234. Furthermore, the third dielectric region 53 covers the additional transformed region 235.

From a practical point of view, the presence of the additional transformed region 235 allows to increase the conductivity of the portion of the conductive channel that is arranged under the additional transformed region 235, without reducing the gate-drain distance.

The HEMT device 200 may be manufactured in the same way as the HEMT device 20 of Figure 2, but for the following differences.

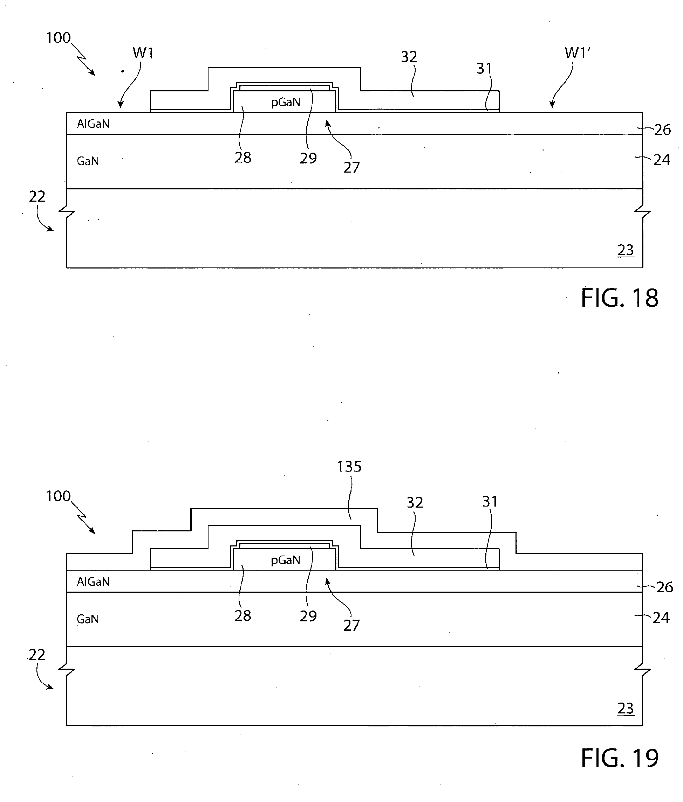

In detail, as shown in Figure 18, the manufacturing process provides for forming, after the formation of the sealing layer 131 and the first dielectric layer 132, an additional first window W1', along with the abovementioned first window W1. The additional first window W1' gives out onto a corresponding exposed portion of the barrier layer 26. The remaining portions of the sealing layer 131 and of the first dielectric layer 132 respectively form the sealing region 31 and the first dielectric region 32.

Then, as shown in Figure 19, the second dielectric layer 135, of silicon nitride of the first type, is formed on the first dielectric region 32 and on the exposed portions of the barrier layer 26, i.e. inside the first window W1 and the additional first window W1'.

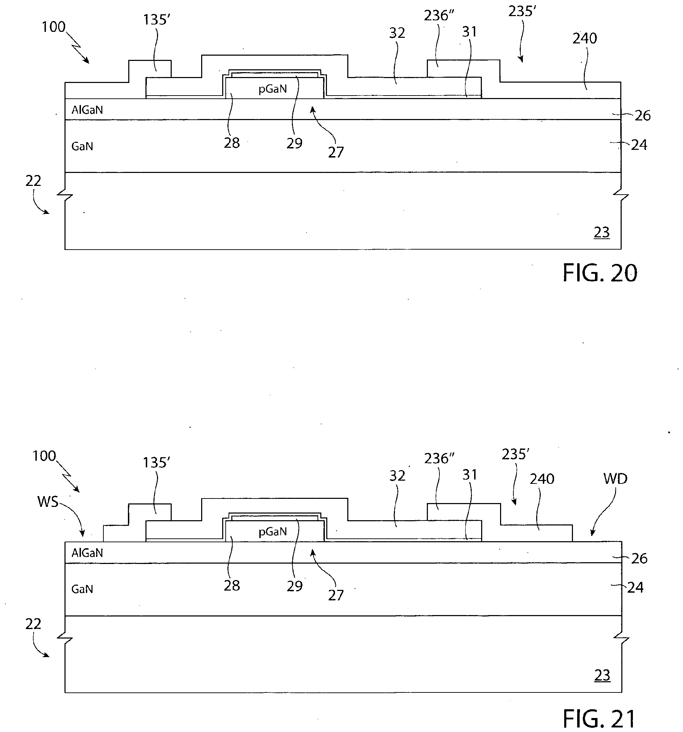

Subsequently, as shown in Figure 20, a portion of the second dielectric layer 135 is selectively removed, so as to expose the first dielectric region 32. The remaining portions of the second dielectric layer 135 form the abovementioned residual dielectric region 135' and an additional residual dielectric region 235'. The additional residual dielectric region 235' forms the second portion 236" of the second dielectric region 234 and a preliminary region 240.

Then, the manufacturing process proceeds in the same manner as described with reference to the Figures 11-16, but for the fact that the drain opening WD is formed through the preliminary region 240 (i.e., by removing a portion of the preliminary region 240), as shown in Figure 21.

Furthermore, though not shown in detail, the thermal treatment causes the transformation of part of the remaining portion of the preliminary region 240 into the additional transformed region 235. Furthermore, the width of the preliminary region 240 along the X axis and the parameters (i.e., temperature and duration) of the thermal treatment, which may be the same as the parameters mentioned with reference to the embodiment of Figure 2, are such that a part of preliminary region 240 does not transform into aluminium nitride, i.e. it remains of silicon nitride and forms the first portion 236' of the second dielectric region 234, thereby maintaining a high breakdown voltage of the HEMT device 200.

Finally, it is clear that numerous variations and modifications may be made to the HEMT device and process described and illustrated herein, all falling within the scope of the invention, as defined in the attached claims.

As an example, the field plate 51 may be absent or may have a different shape.

The HEMT device may be of the normally-on type. As an example, the channel modulating region may be made of a metal material, as opposed to a semiconductor material.

The structure of the semiconductor body may be different. As an example, different materials may be used and/or further layers may be present, such as a spacer layer (e.g., of AlN) interposed between the channel layer 24 and the barrier layer 26.

## Claims

1. A HEMT device (20;200) comprising:
- a semiconductor body (22) forming a semiconductive heterostructure (24,26);
- a gate region (27) arranged on the semiconductor body (22) and elongated along a first axis (Y);
- a gate metal region (50) including a respective lower portion (50'), which is arranged on the gate region (27) and is laterally recessed with respect to the gate region (27), and a respective upper portion (50"), which is arranged on the lower portion (50') and has a width greater that the lower portion (50') along a second axis (X);
- a source metal region (45) extending on the semiconductor body (22) and made at least in part of aluminium;
- a drain metal region (46) of conductive material, extending on the semiconductor body (22), the source metal region (45) and the drain metal region (46) extending on opposite sides of the gate region (27);
- a first conductivity enhancement region (35) of aluminium nitride, extending on the semiconductor body (22) and laterally interposed between the source metal region (45) and the gate region (27), the first conductivity enhancement region (35) being in direct contact with the source metal region (45) and being separated from the gate region (27).

2. The HEMT device according to claim 1, further comprising:
- a first dielectric region (31,32) of a dielectric material different from the silicon nitride, which extends on top of the semiconductor body (22), an inner portion of the first dielectric region (31,32) covering the gate region (27), the lower portion (50") of the gate metal region (50) extending through the inner portion of the first dielectric region (31,32);
- a second dielectric region (34;234) of silicon nitride, which is laterally interposed between the gate region (27) and the drain metal region (46) and includes a respective first portion (36';236'), which extends on the semiconductor body (22) and laterally contacts a first peripheral portion of the first dielectric region (31,32), and a respective second portion (36", 236"), which extends on the first peripheral portion of the first dielectric region (31,32); and
- a field plate (51) of conductive material, which extends in part on the second portion (36"; 236") of the second dielectric region (34;234), in direct contact, and in part on the first dielectric region (31,32), in direct contact;
and wherein the first conductivity enhancement region (35) comprises:
- a respective first portion (38'), which extends on the semiconductor body (22) and laterally contacts the source metal region (45); and
- a respective second portion (38"), which extends on a second peripheral portion of the first dielectric region (31, 32) .

3. The HEMT device according to claim 2, further comprising:
- a second conductivity enhancement region (235) of aluminium nitride, extending on the semiconductor body (22) and laterally interposed, in direct contact, between the first portion (236') of the second dielectric region (234) and the drain metal region (46).

4. The HEMT device according to claim 2 or 3, wherein the first dielectric region (31,32) includes:
- a sealing region (31) of a non-conductive material; and
- a silicon oxide region (32), arranged on the sealing region (31).

5. The HEMT device according to any of the preceding claims, wherein the semiconductor body (22) comprises a channel layer (24) of gallium nitride.

6. The HEMT device according to any of the preceding claims, wherein the gate region (27) comprises a channel modulating region (28) of gallium nitride with a P-type conductivity.

7. A process for manufacturing a HEMT device (20;200), comprising:
- forming a gate region (27) on a semiconductor body (22) forming a semiconductive heterostructure (24,26), the gate region (27) being elongated along a first axis (Y)
- forming a gate metal region (50) including a respective lower portion (50'), which is arranged on the gate region (27) and is laterally recessed with respect to the gate region (27), and a respective upper portion (50"), which is arranged on the lower portion (50') and has a width greater that the lower portion (50') along a second axis (X);
- forming a source metal region (45) extending on the semiconductor body (22) and made at least in part of aluminium;
- forming a drain metal region (46) of conductive material, which extends on the semiconductor body (22), the source metal region (45) and the drain metal region (46) extending on opposite sides of the gate region (27);
- forming a first conductivity enhancement region (35) of aluminium nitride, which extends on the semiconductor body (22) and is laterally interposed between the source metal region (45) and the gate region (27), the first conductivity enhancement region (35) being in direct contact with the source metal region (45) and being separated from the gate region (27).

8. The process according to claim 7, wherein forming the first conductivity enhancement region (35) comprises:
- forming a preliminary dielectric region (135') of silicon nitride, which laterally contacts the source metal region (45); and
- carrying out a thermal treatment to transform the preliminary dielectric region (135') into the first conductivity enhancement region (35).

9. The process according to claim 8, further comprising:
- forming a first dielectric region (31,32) of a dielectric material different from the silicon nitride, which extends on top of the semiconductor body (22), an inner portion of the first dielectric region (31,32) covering the gate region (27), the lower portion (50") of the gate metal region (50) extending through the inner portion of the first dielectric region (31,32);
- forming a second dielectric region (34;234) of silicon nitride, which is laterally interposed between the gate region (27) and the drain metal region (46) and includes a respective first portion (36';236'), which extends on the semiconductor body (22) and laterally contacts a first peripheral portion of the first dielectric region (31,32), and a respective second portion (36", 236"), which extends on the first peripheral portion of the first dielectric region (31,32); and
- forming a field plate (51) of conductive material, which extends in part on the second portion (36"; 236") of the second dielectric region (34;234), in direct contact, and in part on the first dielectric region (31,32), in direct contact;
and wherein forming the first conductivity enhancement region (35) comprises:
- forming a first portion (38') of the first conductivity enhancement region (35), which extends on the semiconductor body (22) and laterally contacts the source metal region (45); and
- forming a second portion (38") of the first conductivity enhancement region (35), which extends on a second peripheral portion of the first dielectric region (31,32).

10. The process according to claim 9, wherein forming the second dielectric region (34) comprises:
- after forming the preliminary dielectric region (135'), forming a dielectric layer (134) of silicon nitride; and then
- selectively removing a portion of the dielectric layer (134), the remaining portion of the dielectric layer (134) forming the second dielectric region (34).

11. The process according to claim 9 or 10, wherein forming a source metal region (45) and a drain metal region (46) comprises:
- forming a source opening (WS) and a drain opening (46) respectively through the preliminary dielectric region (135') and the first portion (36') of the second dielectric region (34); and
- forming the source metal region (45) and the drain metal region (46) so that the source metal region (45) and the drain metal region (46) respectively extend in the source opening (WS) and the drain opening (46).

12. The process according to any of claims 9-11, wherein thepreliminary dielectric region (135') is made of a silicon nitride having a percentage of silicon such that the respective refractive index is greater or equal to 1,95; and wherein the second dielectric region (34) is made of silicon nitride having a percentage of silicon such that the respective refractive index is lower than 1,95.

13. The process according to claim 9, further comprising:
- forming a second conductivity enhancement region (235) of aluminium nitride, extending on the semiconductor body (22) and laterally interposed, in direct contact, between the first portion (236') of the second dielectric region (234) and the drain metal region (46).

14. The process according to claim 13, wherein the drain metal region (46) is made at least in part of aluminium, said process further comprising forming an additional preliminary dielectric region (235'), the preliminary dielectric region (135') and the additional preliminary dielectric region (235') being made of a silicon nitride having a percentage of silicon such that the respective refractive index is greater or equal to 1,95; and wherein forming a source metal region (45) and a drain metal region (46) comprises:
- forming a source opening (WS) and a drain opening (46) respectively through the preliminary dielectric region (135') and the additional preliminary dielectric region (235'); and
- forming the source metal region (45) and the drain metal region (46) so that the source metal region (45) and the drain metal region (46) respectively extend in the source opening (WS) and the drain opening (46);
and wherein said thermal treatment causes the transformation of a part (240) of the additional preliminary dielectric region (235') into the second conductivity enhancement region (235), a part of the additional preliminary dielectric region (235') forming the second dielectric region (234) .
